Europäisches Patentamt

European Patent Office

Office européen des brevets

(11) Veröffentlichungsnummer: **0 301 279 B1**

(12) **EUROPÄISCHE PATENTSCHRIFT**

(45) Veröffentlichungstag der Patentschrift: **21.10.92**

(51) Int. Cl.5: **H01L 39/14**, H01B 12/00

(21) Anmeldenummer: **88110749.4**

(22) Anmeldetag: **06.07.88**

(54) **Leiter, der aus einem Verbundwerkstoff besteht.**

(30) Priorität: **28.07.87 CH 2881/87**

(43) Veröffentlichungstag der Anmeldung:
**01.02.89 Patentblatt 89/05**

(45) Bekanntmachung des Hinweises auf die
Patenterteilung:
**21.10.92 Patentblatt 92/43**

(84) Benannte Vertragsstaaten:
**CH DE FR GB IT LI NL**

(56) Entgegenhaltungen:
**EP-A- 0 292 126**
**EP-A- 0 300 215**
**DE-A- 3 531 770**

**COMMISSION OF EUROPEAN COMMUNITY,
EUROPEAN WORKSHOP ON HIGH Tc SUPER-
CONDUCTORS AND POTENTIAL APPLICA-
TION, PROCEEDINGS, Italia, 1.-3. Juli 1987, P.
DUBOTS et al.: "First characterizations of
high Tc superconducting oxide based multifilamentary wires"**

**EXTENDED ABSTRACTS - HIGH TEMPERATU-
RE SUPERCONDUCTORS PROCEEDINGS OF
SYMPOSIUM S, 1987, SPRING MEETING OF
THE MATERIALS RESEARCH SOCIETY, Ana-**

**heim, 23.-24. April 1987, Seiten 219-221; S.
JIN et al.: "Fabrication of 91K superconducting coils"**

**ADVANCED CERAMIC MATERIALS, Band 2,
Nr. 3B, spezielle Ausgabe, Juli 1987, Seiten
388-400, ACerS, Westerville, Ohio, US; R.W.
McCALLUM et al.: "Problems in the production of YBa2Cu3Ox superconducting wire"**

(73) Patentinhaber: **BBC Brown Boveri Aktiengesellschaft**

**CH-5401 Baden(CH)**

(72) Erfinder: **Meyer, Gundolf, Dr.
Seilersgrabeweg 10
CH-5413 Birmenstorf(CH)**

EP 0 301 279 B1

**Beschreibung**

TECHNISCHES GEBIET

Die vorliegende Erfindung bezieht sich auf das Gebiet der elektrischen Leiter, insbesondere unter Berücksichtigung von supraleitenden Werkstoffen. In neuester Zeit nimmt die Bedeutung von Werkstoffen, welche supraleitende Eigenschaften haben, mehr und mehr zu. Die Entdeckung von neuen supraleitenden Werkstoffen, insbesondere des Typs SE/Ba/Cu/O (SE = Seltene Erden) führte zu einer beträchtlichen Erweiterung der Anwendungsmöglichkeiten für Supraleiter, da diese Stoffe bereits bei Temperaturen oberhalb 50 K supraleitend werden.

Die Erfindung bezieht sich speziell auf die Weiterentwicklung und Verbesserung von Bauteilen, welche einen keramischen Hochtemperatursupraleiter in Band- oder Drahtform enthalten, wobei den Bedürfnissen der industriellen Grossproduktion Rechnung getragen werden soll.

Die Erfindung betrifft einen elektrischen Leiter, welcher

(a) aus einem Verbundwerkstoff besteht, der seinerseits aus einem konventionell leitenden metallischen Teil und einem supraleitenden Teil zusammengesetzt ist; und

(b) bei der Temperatur des flüssigen Stickstoffs normalleitend ist;

STAND DER TECHNIK

Unter den als Festkörper vorhandenen elektrischen, auf der Elektronenwanderung beruhenden Leitern kann man im wesentlichen zwei Gruppen unterscheiden: 1. Die gewöhnlichen metallischen Leiter, wie Kupfer, Silber, Aluminium etc. und deren Legierungen, 2. die Supraleiter und darunter speziell die keramischen gesinterten Hochtemperatur-Supraleiter auf der Basis von Oxyden der seltenen Erdmetalle, des Bariums und des Kupfers. Letztere sind sehr spröde und lassen sich somit als fertige chemische Verbindung nicht mehr formgebend weiterverarbeiten. Ihre Technologie ist in verschiedenen Veröffentlichungen beschrieben worden (vgl. z.B. T. Kawai and M. Kanai, "Preparation of high-$T_c$ Y-Ba-Cu-O Superconductor, Jap. Jour. of Applied Physics, Vol. 26, No. 5, May 1987, pp. 2736-2737; Y. Yamada, N. Fukushima, S. Nakayama and S. Murase, "Critical current density of wire type Y-Ba-Cu-Oxide superconductor", Jap. Jour. of Applied Physics, Vol. 26, No. 5, May 1987, pp. 2865-2866; H. Yoshino, N. Fukushima, M. Miu, S. Nakayama, Y. Amada and S. Murase, "Superconducting wire and coil with zero resistance state at 90 K and current density of 510 A/cm² at 77 K", Toshiba Corporation, R & D Center, Sawai-Ku, Kawasaki-City 210, Japan).

In Anbetracht der Unverformbarkeit dieser kompakten, als Sinterkörper vorliegenden Hochtemperatur-Supraleiterwerkstoffe stellt sich die Frage nach neuen Verarbeitungstechnologien, insbesondere im Hinblick auf eine industrielle Fertigung von Körpern in Band-, Blech- und Drahtform. Es besteht dabei ein grosses Bedürfnis nach der Ausweitung der Verwendungsmöglichkeiten derartiger Supraleiter, da sie bereits oberhalb von 77 K (Siedepunkt des Stickstoffs) supraleitend werden und sich eine komplizierte mehrstufige Kälteeinrichtung mit Helium als Trägermedium erübrigt.

In der älteren Europäischen Anmeldung EP-A-0 292 126 die zum Stand der Technik gemäß Art. 54(3) EPÜ gehört, wird zur Verbesserung der mechanischen Eigenschaften eines oxidischen Supraleiters, der z.B. in Drahtform vorliegt, vorgeschlagen, dem Supraleiterleiterpulver einen gewisssen Anteil an normalleitendem Metall, beispielsweise Ag-Körner beizumischen. Der Anteil an normalleitendem Metall ist dabei allerdings so gering, dass der fertige Leiter durchgehend supraleitende Eigenschaften aufweist.

Ein vergleichbares Vorgehen wird auch in der älteren Europäischen Anmeldung EP-A-0 300 215 die zum Stand der Technik gemäß Art. 54(3) EPÜ gehört, beschrieben, wo z.B. ein Y-Ba-Cu-O-Supraleiterpulver zur Verbesserung der Duktilität mit Metallpulver (Cu, Ag o.ä.) und entsprechenden Metalloxiden vermischt wird. Auch hier ist das Endprodukt ein Leiter mit durchgehend supraleitenden Eigenschaften.

In beiden Fällen muss bei der Herstellung von Leitern darauf geachtet werden, dass die einzelnen supraleitenden Teilchen in der Metallmatrix untereinander ausreichenden Kontakt haben, um die Supraleitung des gesamten Leiters sicherzustellen; der Anteil des Duktilitäts-fördernden Metalls ist daher beschränkt. Darüberhinaus wird die kritische Stromdichte von der Kopplung zwischen den Körnern stark beeinflusst.

DARSTELLUNG DER ERFINDUNG

Es ist daher Aufgabe der Erfindung, einen elektrischen Leiter anzugeben, der hinsichtlich der elektrischen Leitfähigkeit bei tiefen Temperaturen im Bereich des flüssigen Stickstoffs herkömmlichen normalleitenden Metallen und deren Legierungen deutlich überlegen ist und sich ausserdem auf einfache Art herstellen und sich in jede beliebige Form, insbesondere Band-, Blech- und Drahtform verarbeiten lässt.

Die Aufgabe wird bei einem elektrischen Leiter der eingangs genannten Art dadurch gelöst, dass

(c) der konventionell leitende metallische Teil eine Matrix aus Kupfer oder Silber ist; und

(d) der supraleitende Teil aus Partikeln eines keramischen, gesinterten Hochtemperatur-Supraleiters vom Typ $YBa_2Cu_3O_{6,5-7,5}$ besteht, welche Partikel ohne durchgehende supraleitende Verbindung untereinander in die Matrix eingebettet sind.

## KURZE BESCHREIBUNG DER ZEICHNUNG

Die Erfindung wird anhand der nachfolgenden, durch Figuren näher erläuterten Ausführungsbeispiele beschrieben. Es zeigen

Fig. 1    den schematischen Längsschnitt durch einen drahtförmigen Leiter nach der Erfindung;

Fig. 2    den schematischen Querschnitt durch einen drahtförmigen Leiter nach der Erfindung;

Fig. 3    den schematischen Längsschnitt durch einen drahtförmigen Leiter mit Mantel nach der Erfindung; und

Fig. 4    den schematischen Querschnitt durch einen drahtförmigen Leiter mit Mantel nach der Erfindung.

## WEGE ZUR AUSFÜHRUNG DER ERFINDUNG

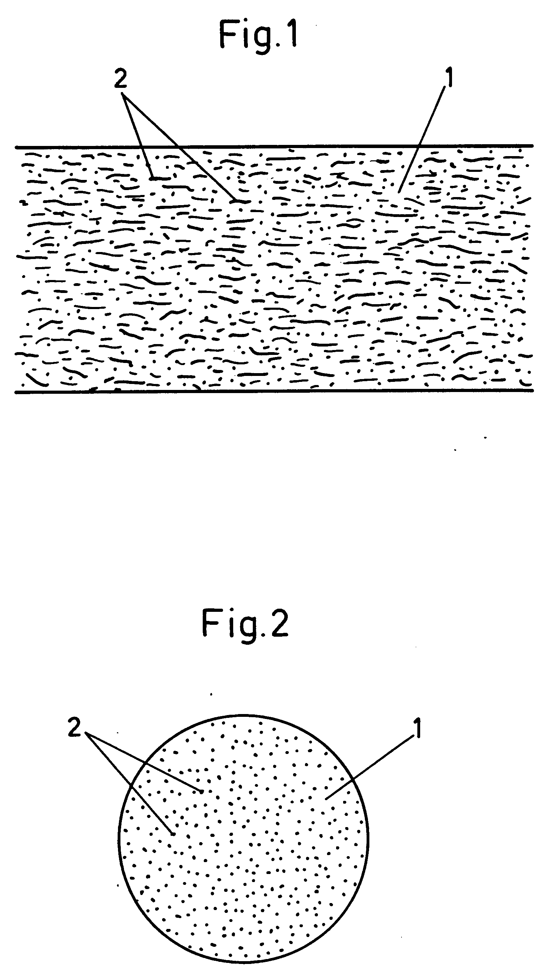

In Fig. 1 ist der schematische Längsschnitt durch einen drahtförmigen elektrischen Leiter nach der Erfindung dargestellt. Der Verbundwerkstoff besteht aus einer Metall-Matrix 1, in welcher, in Längsrichtung zeilenförmig angeordnet, Partikel 2 aus einem Hochtemperatur-Supraleiter eingebettet sind. Es werden dafür Supraleiter des Typs $YBa_2Cu_3O_{6,5-7,5}$ verwendet. Der mittlere Partikeldurchmesser beträgt im fertigen Leiter 0,1 - 100 $\mu$m, vorzugsweise 0,2 - 20 $\mu$m.

Fig. 2 zeigt den schematischen Querschnitt durch einen drahtförmigen Leiter gemäss Fig. 1. Die Bezugszeichen sind die gleichen.

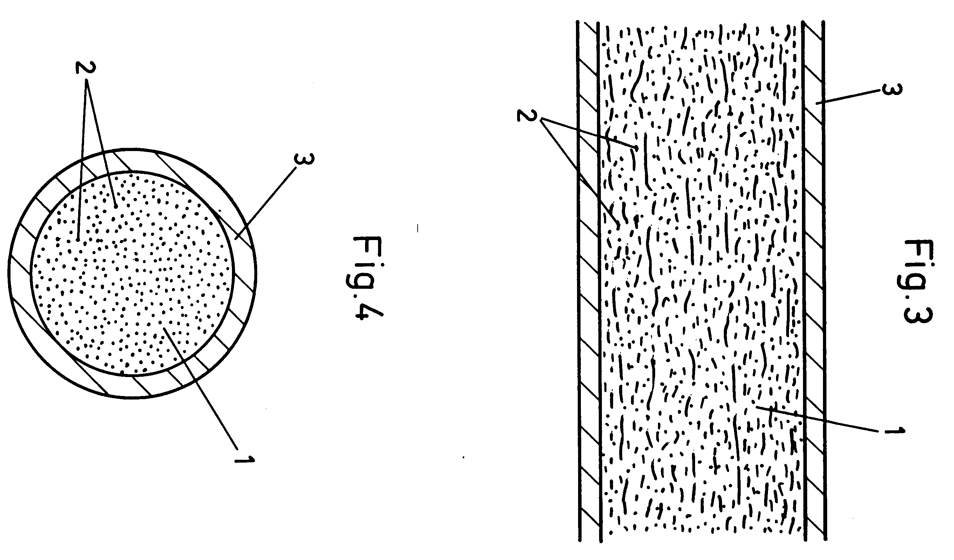

Fig. 3 stellt den schematischen Längsschnitt durch einen drahtförmigen Leiter mit einem Mantel dar. In der Matrix 1 sind Partikel 2 eingebettet. Das Ganze steckt in einem Mantel 3 aus Metall, vorzugsweise aus Kupfer oder Silber.

In Fig. 4 ist der schematische Querschnitt durch einen drahtförmigen Leiter mit Mantel gemäss Fig. 3. Die Bezugszeichen entsprechen denjenigen aus Fig. 3.

## AUSFÜHRUNGSBEISPIEL 1:

Siehe Figuren 1 und 2 !

In eine zylindrische Form von 12 mm Durchmesser und 250 mm Länge wurden ca. 100 g einer Pulvermischung eingefüllt und festgestampft. Die Pulvermischung bestand zu 50 Gew.-% aus Kupferpulver mit einer mittleren Korngrösse von 250 $\mu$m und 50 Gew.-% aus einem supraleitenden Keramikpulver der Zusammensetzung $YBa_2Cu_3O_7$ mit einer mittleren Korngrösse von 50 $\mu$m. Die Pulvermischung wurde zunächst durch Kaltpressen zu einem Stab von ca. 10 mm Durchmesser verdichtet. Der vorverdichtete Stab wurde durch heiss-isostatisches Pressen bei einer Temperatur von 300 °C während 3 h weiter verdichtet, wobei sein Durchmesser noch ca. 8 mm betrug. Durch Rundhämmern bei einer Temperatur von 250 °C wurde der Stab in mehreren Stichen auf einen Durchmesser von 4 mm reduziert. Nun erfolgte ein Zwischenglühen zur Verminderung der inneren Spannungen bei einer Temperatur von 350 °C während 1/2 h. Schliesslich wurde der Draht in mehreren Stichen auf einen Enddurchmesser von 1 mm kalt heruntergezogen.

Die Untersuchung ergab eine mittlere Korngrösse der supraleitenden Partikel 2 von ca. 20 $\mu$m, deren Anordnung in der Metall-Matrix 1 (Kupfer) zeilenförmig war.

## AUSFÜHRUNGSBEISPIEL 2:

Siehe Figur 1 und 2 !

Ca. 300 g einer Pulvermischung von 30 Gew.-% Kupferpulver (mittlere Korngrösse 500 $\mu$m) und 70 Gew.-% Supraleiterpulver $YBa_2Cu_3O_{7,2}$ (mittlere Korngrösse 80 $\mu$m) wurden in den Rezipienten einer Strangpresse gegeben und festgestampft. Der Rezipient hatte zylindrische Form (Durchmesser 25 mm, Länge 150 mm). Nun wurde die Oeffnung der Matritze durch einen Pfropfen verschlossen und durch Stempeldruck bei 300 °C während 10 min heissverdichtet. Nach Entfernen des Pfropfens aus der Matritzenöffnung wurde bei einer Temperatur von 350 °C ein Draht von 5 mm Durchmesser stranggepresst: Reduktionsverhältnis 25 : 1. Der Draht wurde hierauf kalt auf einen Durchmesser von 0,8 mm gezogen.

Die Untersuchung ergab eine mittlere Korngrösse der Partikel 2 aus supraleitendem Stoff von 15 $\mu$m. Die Textur in der Metall-Matrix 1 war zeilenförmig.

## AUSFÜHRUNGSBEISPIEL 3:

Siehe Figuren 1 und 2 !

In einer Hochenergie-Kugelmühle (Attritor) wurden 240 g Silberpulver (60 Gew.-%) mit 160 g Supraleiterpulver (40 Gew.-%) der Zusammensetzung $YBa_2Cu_3O_{6,8}$ mechanisch legiert. Die mittlere Korngrösse des Silberpulvers betrug 4 $\mu$m, diejenige des Supraleiterpulvers 0,5 $\mu$m. Das mechanisch legierte Pulver wurde in eine Form von 18 mm Durchmesser und 400 mm Länge abgefüllt und festgestampft. Danach wurde eine Vorverdichtung im kalten Zustand vorgenommen. Der Stab hatte nun einen Durchmesser von 16 mm. Ein Rundhämmern brachte den Stab in mehreren Stichen auf einen Durchmesser von 6 mm. Es folgte ein Spannungsfreiglühen von 1/2 h bei einer Temperatur von 350 °C. Danach wurde der Draht auf einen Durchmesser von 1,2 mm kalt herunter gezogen.

Die mittlere Korngrösse der supraleitenden Partikel 2 betrug ca. 1 $\mu$m. Es konnte im Schliffbild die typische Zeilentextur in der Matrix 1 beobachtet werden.

AUSFÜHRUNGSBEISPIEL 4:

Siehe Figuren 3 und 4 !

Es wurde ein Mantel 3 aus Metall in Form eines Kupferrohres von 18 mm Aussen- und 16 mm Innendurchmesser verwendet. Das Rohr war 300 mm lang und hatte ein Fassungsvermögen von ca. 60 cm$^3$. Es wurden total ca. 240 g einer Pulvermischung in das Rohr abgefüllt und festgestampft. Die Pulvermischung bestand aus 60 g (25 Gew.-%) Kupferpulver und 180 g (75 Gew.-%) eines supraleitenden Keramikpulvers der Zusammensetzung Y Ba$_2$ Cu$_3$ O$_7$, welches zuvor metallisiert (verkupfert) worden war. Die mittlere Korngrösse des Kupferpulvers betrug 100 $\mu$m, diejenige des Supraleiterpulvers 20 $\mu$m. Der Mantel 3 wurde unter Vakuum an beiden Enden verschlossen und die auf diese Weise hergestellte abgeschlossene Kapsel mit der Pulvermischung auf eine Temperatur von 320 °C aufgeheizt und in den Rezipienten einer Strangpresse gebracht. Durch Strangpressen wurde ein ummantelter Draht von 4 mm Durchmesser hergestellt. Reduktionsverhältnis 20 : 1. Daraufhin wurde der Draht bei einer Temperatur von 200 °C auf einen Durchmesser von 0,7 mm heruntergezogen.

Die Untersuchung zeigte eine mittlere Korngrösse der Supraleiterpartikel von 12 $\mu$m in typischer Zeilenanordnung.

AUSFÜHRUNGSBEISPIEL 5:

Siehe Figuren 3 und 4 !

Ein Mantel 3 aus Metall in Form eines flachkantigen Rechteckrohres aus Silber mit den Aussenabmessungen 23 mm x 11 mm und den Innenabmessungen 20 mm x 8 mm (Länge 500 mm) wurde mit ca. 320 g einer Pulvermischung gefüllt. Letztere bestand zu 200 g (62,5 Gew.-%) aus Silberpulver und zu 120 g (37,5 Gew.-%) aus Supraleiterpulver der Formel Y Ba$_2$ Cu$_3$ O$_{6,7}$. Die mittlere Korngrösse des Silberpulvers betrug 50 $\mu$m, diejenige des Supraleiterpulvers 10 $\mu$m. Es wurde gleich wie in Beispiel 4 vorgegangen. Nachdem eine abgeschlossene vakuumdichte flache Kapsel hergestellt war, wurde diese einem Walzprozess bei einer Temperatur von 280 °C unterworfen. Es wurde zunächst ein Flachstab von 2,8 mm Dicke mit einem Kern von 2 mm Dicke (Wandstärke des Mantels 3: 0,4 mm) gewalzt. Dieser Flachstab wurde durch Kaltziehen zu einem Band von 0,4 mm Dicke (Kern: 0,3 mm; Wandstärke des Mantels 3: 0,05 mm) und 20 mm Breite weiterverarbeitet.

Die Korngrösse der Supraleiterpartikel betrug im Mittel ca. 5 $\mu$m. Die Partikel hatten Flockenform und waren in Zeilen angeordnet.

AUSFÜHRUNGSBEISPIEL 6:

Auf ein Substrat in Form eines quadratischen Kupferbleches von 100 mm Seitenlänge und 1 mm Dicke wurde in einer Zelle nach der galvanischen/elektrophoretischen Methode aus einem Kupfer im Elektrolyten und Supraleiterpartikel in Suspension enthaltenden Bad eine Schicht abgeschieden. Die Aufschlämmung des Supraleiterpulvers der Zusammensetzung Y Ba$_2$ Cu$_3$ O$_7$ im Bad war so bemessen, dass ein Anteil von 30 Gew.-% Supraleiterpartikel in der Schicht eingebaut wurde, während die eigentliche galvanische Abscheidung die 70 Gew.-% Kupfer umfasst.

Die durchschnittliche Korngrösse der Supraleiterpartikel in der abgeschiedenen Schicht betrug 60 $\mu$m. Nachdem die poröse Schicht eine Dicke von ca. 10 mm erreicht hatte, wurde die auf diese Weise gebildete Platte aus dem Bad herausgenommen, gewaschen, gereinigt und getrocknet. Durch Kaltpressen wurde die Platte in der Dicke auf ein Mass von 7 mm reduziert und auf nahezu theoretische Dichte verdichtet. Durch nachfolgendes Kaltwalzen wurde ein Band erzeugt, dessen aktive Schicht eine Dicke von 0,5 mm und das Substrat eine solche von 0,05 mm aufwies.

Die Korngrösse der Partikel des supraleitenden Stoffes betrug im Mittel 25 $\mu$m. Die Partikel hatten Flockenform mit Anordnung ihrer Hauptfläche parallel zur Blechebene.

Die Erfindung ist nicht auf die Ausführungsbeispiele beschränkt. Als Metall-Matrix 1 wie als Mantel 3 aus Metall können grundsätzlich alle Metalle und Legierungen, welche gute elektrische Leiter sind, Verwendung finden. Bevorzugt sind Kupfer und Silber und deren Legierungen. Allenfalls könnten noch Gold wegen seiner Korrosions- und Oxydationsbeständigkeit oder Aluminium wegen seiner geringen Dichte und verhältnismässig hohen Festigkeit in Frage kommen. Der Mantel 3 weist vorteilhafterweise eine Dicke von 5 bis 20 % des Durchmessers des die Matrix 1 bildenden Körpers auf. Für andere Querschnitte (Quadrat, Rechteck, Sechseck etc) gelten analoge Verhältnisse. Der mittlere Partikeldurchmesser beträgt 0,1 - 100 $\mu$m, vorzugsweise 0,2 - 20 $\mu$m. Der aus dem besagten Verbundwerkstoff bestehende elektrische Leiter weist vorzugsweise Band-, Blech- oder Drahtform auf und hat in Längsrichtung bei 77 K die höchste elektrische Leitfähigkeit (durch Zeilenanordnung begünstigt). Die Verformung und damit die Ausbildung der Zeilenstruktur kann sich auf einen marginalen Anteil beschränken, z.B. auf eine Verdichtungs- oder Glättungsoperation der Oberfläche.

**Patentansprüche**

1. Elektrischer Leiter, welcher
   (a) aus einem Verbundwerkstoff besteht, der seinerseits aus einem konventionell leitenden metallischen Teil und einem supraleitenden Teil zusammengesetzt ist; und
   (b) bei der Temperatur des flüssigen Stickstoffs normalleitend ist;
   dadurch gekennzeichnet, dass
   (c) der konventionell leitende metallische Teil eine Matrix (1) aus Kupfer oder Silber ist; und
   (d) der supraleitende Teil aus Partikeln (2) eines keramischen, gesinterten Hochtemperatur-Supraleiters vom Typ $YBa_2Cu_3O_{6.5-7.5}$ besteht, welche Partikel (2) ohne durchgehende supraleitende Verbindung untereinander in die Matrix (1) eingebettet sind.

2. Elektrischer Leiter nach Anspruch 1, dadurch gekennzeichnet, dass der mittlere Durchmesser der Partikel (2) des keramischen, gesinterten Hochtemperatur-Supraleiters 0,1 -100 $\mu$m misst.

3. Elektrischer Leiter nach Anspruch 2, dadurch gekennzeichnet, dass die Partikel (2) des keramischen, gesinterten Hochtemperatur-Supraleiters in Stromrichtung zeilenförmig angeordnet sind.

4. Elektrischer Leiter nach Anspruch 3, dadurch gekennzeichnet, dass der Leiter zusätzlich einen Mantel (3) aus einem reinen Metall oder einer Legierung aufweist.

5. Elektrischer Leiter nach Anspruch 4, dadurch gekennzeichnet, dass der Mantel (3) aus Kupfer besteht und eine Dicke von 5 bis 20 % des Durchmessers des die Matrix (1) bildenden Körpers hat.

**Claims**

1. Electrical conductor which
   (a) consists of a composite material which is in turn composed of a conventionally conducting metallic part and a superconducting part; and
   (b) is normally conducting at the temperature of liquid nitrogen;
   characterised in that
   (c) the conventionally conducting metallic part is a matrix (1) of copper or silver; and
   (d) the superconducting part consists of particles (2) of ceramic sintered high-temperature superconductor of the $YBa_2Cu_3O_{6.5-7.5}$ type, which particles (2) are embedded in the matrix (1) without continuous superconduction connection to one another.

2. Electrical conductor according to Claim 1, characterised in that the mean diameter of the particles (2) of the ceramic sintered high-temperature superconductor is 0.1 - 100 $\mu$m.

3. Electrical conductor according to Claim 2, characterised in that the particles (2) of the ceramic sintered high-temperature superconductor are arranged rectilinearly in the current direction.

4. Electrical conductor according to Claim 3, characterised in that the conductor additionally has a sheath (3) composed of a pure metal or an alloy.

5. Electrical conductor according to Claim 4, characterised in that the sheath (3) is composed of copper and has a thickness of 50 to 20% of the diameter of the body forming the matrix (1).

**Revendications**

1. Conducteur électrique,
   (a) lequel se compose d'un matériau composite, qui lui-même est formé d'une partie métallique qui conduit le courant au sens conventionnel du terme et d'une partie supraconductrice; et
   (b) qui, à la température de l'azote liquides est un conducteur électrique normal;
   caractérisé en ce que
   (c) la partie métallique qui conduit le courant au sens conventionnel du terme est une matrice (1) en cuivre ou en argent; et
   (d) la partie supraconductrice se compose de particules (2) d'un supraconducteur haute température en céramique frittée du type $YBa_2Cu_{6.5-7.5}$, les particules (2) étant incorporées sans connections supraconductrices ininterrompues entre elles dans la matrice (1).

2. Conducteur électrique selon la revendication 1, caractérisé en ce que le diamètre moyen des particules (2) du supraconducteur haute température en céramique frittée mesure de 0,1 à 100 microns.

3. Conducteur électrique selon la revendication 2, caractérisé en ce que les particules (2) du supraconducteur haute température en céramique frittée sont agencées en lignes dans la direction du courant.

4. Conducteur électrique selon la revendication 3, caractérisé en ce que le conducteur possède de plus une enveloppe (3) en métal pur ou en alliage.

5. Conducteur électrique selon la revendication 4, caractérisé en ce que l'enveloppe (3) se compose de cuivre et a une épaisseur de 5 à 20% du diamètre du corps qui constitue la matrice (1).

# Fig.1

# Fig.2

# Fig.3

# Fig.4